# EUROPÄISCHE PATENTSCHRIFT

(11) **EP 1 012 866 B1**
(45) Veröffentlichungstag und Bekanntmachung des Hinweises auf die Patenterteilung: **23.05.2007**
(21) Anmeldenummer: 98951265.2
(22) Anmeldetag: 29.08.1998
(51) Int. Cl.: H01J 37/153

(54) **VERFAHREN ZUR BESEITIGUNG AXIALER BILDFEHLER ERSTER, ZWEITER UND DRITTER ORDNUNG BEI KORREKTUR DES ÖFFNUNGSFEHLERS DRITTER ORDNUNG IN ELEKTRONENOPTISCHEN SYSTEMEN**
METHOD FOR ELIMINATING FIRST, SECOND AND THIRD-ORDER AXIAL IMAGE DEFORMATIONS DURING CORRECTION OF THE THIRD-ORDER SPHERICAL ABERRATION IN ELECTRON OPTICAL SYSTEMS
PROCEDE POUR ELIMINER DES DEFAUTS D'IMAGE AXIAUX DE DEUXIEME ET TROISIEME ORDRE LORS DE LA CORRECTION DU DEFAUT D'OUVERTURE DE TROISIEME ORDRE DANS DES SYSTEMES OPTO-ELECTRONIQUES

(30) Priorität: 08.09.1997 DE 19739290
(43) Veröffentlichungstag der Anmeldung: 28.06.2000
(73) Patentinhaber: Ceos Corrected Electron Optical Systems GmbH, 69120 Heidelberg (DE)
(72) Erfinder: HAIDER, Maximilian, D-69251 Gaiberg (DE); UHLEMANN, Stephan, D-69126 Heidelberg (DE)
(74) Vertreter: Pöhner, Wilfried Anton, Dr.
(86) Internationale Anmeldenummer: PCT/DE1998/002596
(87) Internationale Veröffentlichungsnummer: WO 1999/013490

(56) Entgegenhaltungen:
- EP-A- 0 451 370
- US-A- 4 414 474
- BECK V D: "Method for Producing Optical Aberrations of Variable Magnitude. November 1980." IBM TECHNICAL DISCLOSURE BULLETIN, Bd. 23, Nr. 6, November 1980, Seiten 2586-2589, XP002090287 New York, US
- ZACH J ET AL: "Correction of spherical and chromatic aberration in a low voltage SEM" OPTIK, JAN. 1995, GERMANY, Bd. 98, Nr. 3, Seiten 112-118, XP002090288 ISSN 0030-4026
- ROSE H: "Correction of aperture aberrations in magnetic systems with threefold symmetry" PROCEEDINGS OF THE 1ST CONFERENCE ON CHARGED PARTICLE OPTICS, GIESSEN, WEST GERMANY, 8-11 SEPT. 1980, Bd. 187, Nr. 1, Seiten 187-199, XP002090289 ISSN 0167-5087, Nuclear Instruments and Methods in Physics Research, 1 Aug. 1981, Netherlands
- ZEMLIN F ET AL: "Coma-free alignment of high resolution electron microscopes with the aid of optical diffractograms" ULTRAMICROSCOPY, 1978, NETHERLANDS, Bd. 3, Nr. 2, Seiten 49-60, XP002090290 ISSN 0304-3991 in der Anmeldung erwähnt

## Beschreibung

Die Erfindung bezieht sich auf Verfahren zur Beseitigung axialer Bildfehler erster, zweiter und dritter Ordnung bei Korrektur des Öffnungsfehlers dritter Ordnung in elektronenoptischen Systemen mit Hexapolen.

Allgemein bekannt ist, daß das Auflösungsvermögen von Rundlinsen in elektronenoptischen Systemen durch den Öffnungsfehler dritter Ordnung (sphärische Aberration) begrenzt wird. Auf zahlreichen Anwendungsgebieten, wie dem der Elektronenmikroskopie, wird das Leistungsvermögen eines elektronenoptischen Systemes durch das Auflösungsvermögen bestimmt, so daß zur Verbesserung derartiger Geräte erhebliche Anstrengungen zur Beseitigung des Öffnungsfehlers dritter Ordnung unternommen werden. Einer der erfolgversprechendsten Lösungen ist der Einsatz von aus unrunden Linsensystemen bestehenden Korrektiven, wie sie z. B. in der EP 0451370 beschrieben sind, wo ein aus Rundlinsen und Hexapolen gebildetes Korrektiv in Richtung des Strahlenganges hinter dem zu korrigierenden Linsensystem, was in der Regel die Objektivlinse eines Elektronenmikroskopes darstellt, nachgeordnet wird.
Im Falle des vorgeschilderten Korrektives wie bei allen anderen elektronenoptischen Systemen mit Korrektur des Öffnungsfehlers dritter Ordnung treten in der Praxis u.a. das Auflösungsvermögen beeinträchtigende Justierfehler auf, bei denen es sich primär um die axialer Bildfehler erster, zweiter und dritter Ordnung handelt, deren Beseitigung zur Erreichung der optimalen Auflösung erforderlich ist. Die als Justierfehler auftretenden axialen Bildfehler bei Korrektur des Öffnungsfehlers dritter Ordnung sind wie folgt:
- C₁: Defokussierung
- A₁: 2-zähliger axialer Astigmatismus erster Ordnung
- B₂: axiale Koma zweiter Ordnung
- A₂: 3-zähliger Astigmatismus zweiter Ordnung
- A₃: 4-zähliger Astigmatismus dritter Ordnung
- S₃: 2-zähliger Sternfehler dritter Ordnung.

Für Justierfehler, die auch als parasitäre Fehler bezeichnet werden, gilt, daß ihr Wert größenmäßig gering ist und im Falle idealer Justierung zu Null wird.
Die bisherigen Verfahren charakterisieren sich dadurch, daß die Justierfehler sukzessive bei jedem abbildenden Element des elektronenoptischen Systems und fortschreitend in Richtung der Strahlausbreitung beseitigt werden.

Aus der Veröffentlichung Rose, Optik Volume 85 No. 1 (1990) 19-24 ist bereits bekannt, Hexapolfelder mit Dipol- und Quadrupolfeldern zu überlagern, um auf diese Weise Justierfehler, die durch eine Abweichung einer Achse des Hexapolfeldes von der optischen Achse entstanden sind, wieder zu beseitigen. Justierfehler werden also lokal am Ort ihres Entstehens sofort kompensiert, um die Entstehung und Ausbildung von Kombinationsfehlern zu vermeiden.

Ausgehend von diesem Stand der Technik hat sich die Erfindung die Schaffung von Justierverfahren zur Aufgabe gemacht, mit deren Hilfe die Beseitigung der axialen Bildfehler erster, zweiter und dritter Ordnung vorgenommen werden kann.

Als Lösung werden nachfolgend Korrekturverfahren erläutert, die eine Lehre geben, auf welche Art und Weise einzelne axiale Bildfehler zweiter und dritter Ordnung korrigiert werden können; zum anderen wird ein Justierverfahren zur Beseitigung sämtlicher axialer Bildfehler sowohl der ersten als auch der zweiten und der dritten Ordnung bei einem Korrektiv zur Beseitigung des sphärischen Aberration dritter Ordnung angegeben. Die Größen α̅ und γ̅ bezeichnen die jeweils komplex konjugierten Größen. Nachfolgend werden die Korrektur der einzelnen Bildfehler in Zusammenhang mit der Schilderung des Justierverfahrens näher erläutert.

Der erste Schritt als Voraussetzung zur Beseitigung der Justierfehler ist die Bestimmung der Größe der jeweiligen Fehlerkoeffizienten. Ein entscheidender Unterschied gegenüber dem aus dem Stande der Technik bekannten Verfahren besteht darin, daß die Bildfehler hinter dem aus in aller Regel mehreren Linsen bestehenden Gesamtsystem genau in der Bildebene gemessen werden, so daß die Fehler nur in ihrer Gesamtheit und in gegenseitiger Überlagerung erfaßt werden.
Zur Bestimmung des Wertes der jeweiligen Bildfehlerkoeffizienten werden Bilder mit gegen die optische Achse gekippten Strahlengängen aufgenommen, wobei die einzelnen Bilder im Vergleich zueinander Unterschiede im Neigungswinkel und Azimut der Beleuchtungsachse aufweisen. Hierbei ist die Zahl der Bilder so groß, daß das Gleichungssystem mindestens bestimmt ist. Die Auswertung erfolgt in der Weise, daß ein Diffraktogramm hergestellt wird, entweder auf analoge Weise durch Beugung oder aber durch eine Fouriertransformation auf mathematischem Wege. Aus den Beugungsbildern lassen sich die Bildfehler C₁, A₁ nach einer bekannten Methode ermitteln. Wir verweisen auf den Beitrag von F. Zemlin et al., Ultramicroscopy 3 (1978) 49. Die weiteren vier komplexen Justierfehler und der reelle Öffnungsfehler lassen sich durch ein Gleichungssystem ermitteln, das aus dem Eikonal hergeleitet wird (s. Zemlin aaO). Bei den vorerwähnten fünf Bildfehlern ist im speziellen ein aus neun reellen Gleichungen bestehendes Gleichungssystem herzuleiten und zu lösen. Auf diesem Wege erfolgt die Ermittlung der zu beseitigenden Fehlerkoeffizienten.

Zur Beseitigung der Justierfehler sind Schritte in der nachfolgend beschriebenen Reihenfolge vorzunehmen.
Die Beeinflußung und Beseitigung der Defokussierung und des zweizähligen axialen Astigmatismus erster Ordnung sind trivial; sie erfolgen durch Änderung der Fokussierung (im Falle C₁) und durch Überlagerung eines Quadrupolfeldes (im Falle A₁).
Nach Beseitigung der Fehler erster Ordnung sind als nächstes die Fehler zweiter Ordnung, also die axiale Koma B₂ und der dreizählige axiale Astigmatismus A₂ zu korrigieren, da dann erst eine ausreichend genaue Ermittlung der Bildfehler dritter Ordnung und demzufolge auch deren Korrektur möglich wird. Nachdem der Wert in der vorbeschriebenen Weise ermittelt wurde, erfolgt die Korrektur wie nachfolgend beschrieben:

### Axiale Koma zweiter Ordnung B₂:

Die Beseitigung kann durch einen sog. Komastigmator erfolgen. Hierzu werden im Korrektivsystem einem Paar von Hexapolen jeweils ein Quadrupolfeld gleicher Stärke überlagert, wobei das Produkt aus dem Vorzeichen des Hexapolfeldes und dem des zugehörigen Quadrupolfeldes antisymmetrisch, also einander entgegen gerichtet sind. Diese Bedingung stellt sicher, daß kein Astigmatismus 1. Ordnung erzeugt wird. Die Stärke und die Orientierung dieser Quadrupolfelder wird durch die gemessenen Koma bestimmt.

Zur Realisierung der Quadrupolfelder stehen verschiedene Möglichkeiten zur Verfügung.
Dies kann in der Praxis dadurch geschehen, daß in den Hexapolen des Korrektivs ein zusätzliches Quadrupolfeld erzeugt wird.

Eine andere Möglichkeit der Erzeugung der Quadrupolfelder kann durch paralleles Verschieben der optischen Achse parallel zur Achse des Hexapols bestehen.

### Dreizähliger axialer Astigmatismus zweiter Ordnung A₂:

Hier erfolgt die Korrektur durch ein zusätzliches Hexapolfeld, dessen Stärke und Richtung ebenfalls durch den ermittelten Fehlerkoeffizienten bestimmt ist. Die Verwirklichung erfolgt durch Erzeugen eines derartigen Hexapolfeldes. Eine andere Möglichkeit der Felderzeugung besteht im virtuellen Verdrehen der Hexapole des Korrektives gegeneinander, wodurch ebenfalls ein dreizähliges Feld erzeugt wird. Die Umsetzung erfolgt durch Anordnung einer magnetischen Rundlinse zwischen den beiden Hexapolen bzw. die Verwendung der bereits vorhandenen. Der Vorteil dieser Methode besteht darin, daß man sich den andernfalls notwendigen Weg der Verwendung einer zwölfpoligen Linse zur Erzeugung eines Hexapolfeldes beliebiger Größe und Ausrichtung erspart.

Nachdem nunmehr die Bildfehler erster und zweiter Ordnung korrigiert sind, lassen sich die Werte der Bildfehler dritter Ordnung, nämlich der 4-zählige axiale Astigmatismus A₃ und der 2-zählige Sternfehler S₃, in der oben beschriebenen Weise ermitteln. Die Korrektur dieser axialen Bildfehler folgt einem gemeinsamen und durch die Erfindung erstmals vorgeschlagenen allgemeinen Prinzip. Hierzu wird zur Korrektur des axialen Bildfehlers der gleiche außeraxiale Bildfehler höherer Ordnung genutzt und durch Verschieben oder Verkippen der optischen Achse soweit zur Wirkung gebracht, bis eine Kompensation eintritt. Gleichheit des Bildfehlers meint im Sinne der Erfindung gleiches Verhalten, also gleiche Abhängigkeit vom komplexen Öffnungswinkel α und dessen komplex konjugierter α̅. Dabei entspricht die Potenz der Bildkoordinate γ der Differenz zwischen der Ordnung des zur Korrektur genutzten außeraxialen Fehlers und der Ordnung des zu korrigierenden axialen Bildfehlers.

In vielen Anwendungsfällen, so aus Gründen der Beherrschbarkeit und Übersichtlichkeit oder bei der Korrektur im Wert kleiner Fehler, wie sie bei der Justierung auftreten, wird der außeraxiale Fehler mit linearer Abhängigkeit von γ genutzt werden. Bei einem axialen Anteil hätte man beispielsweise αⁿ, wobei der zugehörige außeraxiale Anteil - unter der Annahme der Linearität - dann lautet αⁿ·^{γ}. Beim axialen Sternfehler 3. Ordnung ergibt sich ein α³, so daß der zur Korrektur genutzte außeraxiale und in γ lineare Sternfehler der 4. Ordnung α³γ darstellt. Zur Korrektur des 4-zähligen axialen Astigmatismus 3. Ordnung α̅³ wird der außeraxiale Astigmatismus 4. Ordnung genutzt.

Durch entsprechendes Verschieben der optischen Achse, vorzugsweise im Bereich des Zwischenbildes, läßt sich auf den außeraxialen Fehler Einfluß nehmen, so daß bei entsprechender Justierung eine gegenseitige Kompensation d. h. ein Beseitigung des axialen Fehleranteiles mit Hilfe des im oben erläuterten Sinn zugehörigen außeraxialen Bildfehlers erfolgt.
Auf diese Weise lassen sich der Sternfehler als auch der vierzählige Astigmatismus 3. Ordnung beseitigen.

Die Korrektur der Fehler 3. Ordnung in der beschriebenen Weise beeinflußt prinzipiell die Fehler der niedrigeren Ordnungen.

Aus diesem Grunde muß mit Beendigung des Korrekturvorganges der Bildfehler dritter Ordnung die hierdurch erzeugten Fehler zweiter und erster Ordnung gemessen und anschließend in der oben beschriebenen Weise (nochmals) korrigiert werden. Durch Verwendung geeigneter Justierelemente läßt sich erreichen, daß die 1. und 2. Ordnung eine Korrektur ohne oder nur mit geringfügiger Beeinflußung der Fehler dritter Ordnung erfährt. Hierzu zählen die in den Ansprüchen 6 - 9 geschilderten Verfahren.

Weitere Einzelheiten, Merkmale und Vorteile der Erfindung lassen sich dem nachfolgenden Beschreibungsteil entnehmen, in dem anhand der Zeichnung die Erfindung näher erläutert wird. Es zeigen in schematischer Darstellung:
Figur 1: Das Prinzip der Korrektur der axialen Koma zweiter Ordnung B₂
Figur 2: Das Korrekturprinzip des dreizähligen axialen Astigmatismus zweiter Ordnung A₂,
Figur 3: Die Korrektur des axialen Astigmatismus und des Sternfehlers jeweils von dritter Ordnung.

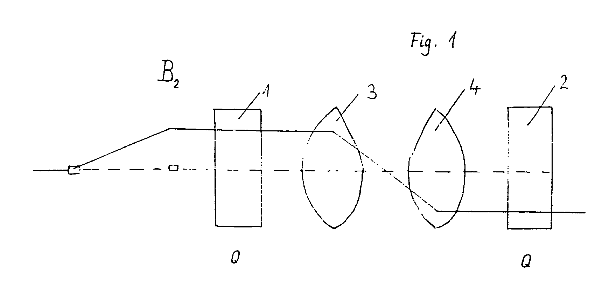

In Figur 1 verläuft die in gestrichelter Linie dargestellte optische Achse in der Horizontalen. Die Hexapole 1 und 2 begrenzen nach außen das durch die beiden Rundlinsen 3 und 4 gebildete System. Zur Korrektur der axialen Koma zweiter Ordnung B₂ wird wie durch den Buchstaben Q angedeutet, in den beiden Hexapolen 1 und 2 ein Quadrupolfeld überlagert, welches einander entgegengerichtet ist. Bei gleichem Vorzeichen der Hexapolfelder 1 und 2 und gegengesetztem Vorzeichen der Quadrupolfelder Q ergibt sich eine Antisymmetrie, durch die die Erzeugung eines Astigmatismus erster Ordnung vermieden wird. Zur Kompensierung sind die Quadrupolfelder in Stärke und Richtung dem Wert der gemessenen Koma einzustellen.
Neben der direkten Erzeugung eines Quadrupolfeldes läßt sich ein derartiges Feld auf elegante Weise dadurch herstellen, daß die optische Achse parallel zur Achse des Hexapols verschoben wird, wodurch in Abhängigkeit vom Verschiebeweg ein Quadrupolfeld zusätzlich erzeugt wird.

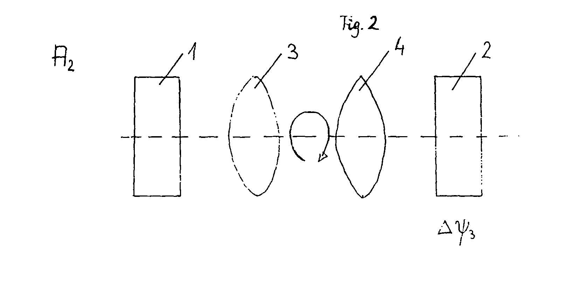

Die Figur 2 befaßt sich in prinzipenhaften Darstellung mit der Korrektur des dreizähligen axialen Astigmatismus zweiter Ordnung. Hierzu wird ein Hexapolfeld entsprechend der Stärke und Richtung des zu korrigierenden Fehlerwertes erzeugt. Zwischen den beiden Hexapolen 1 und 2 befindet sich ein magnetisches Rundlinsensystem 3,4, durch das eine Larmor-Drehung des abbildenden Strahlenganges erfolgt und somit ein virtuelles Verdrehen der beiden Hexapole 1,2 relativ gegeneinander erzeugt. Hierdurch läßt sich ein in seiner Größe einstellbares Hexapolfeld ψ₃ zusätzlich erzeugen.

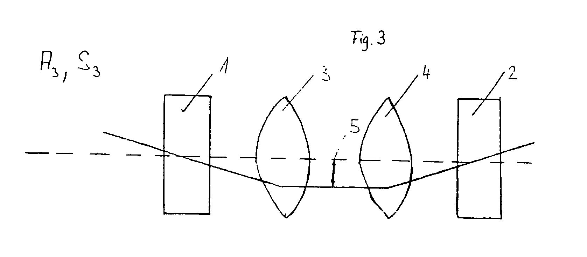

Figur 3 zeigt ebenfalls zwei Hexapole, mit zwei darin angeordneten Rundlinsen 3,4 zwischen den ein Zwischenbild 5 erzeugt wird. Durch einen Versatz in der Ebene des Zwischenbildes lassen sich die gleichen außeraxialen Bildfehler höherer Ordnung zur Wirkung bringen und zur Kompensation nutzen. In der Regel wird man den außeraxialen Fehler nächsthöherer Ordnung also mit linearem γ oder γ̅ hierzu verwenden. Zur Korrektur des axialen Sternfehlers der Ordnung S₃ wird deshalb der außeraxiale Sternfehler vierter Ordnung α³γ und beim vierzähligen axialen Astigmatismus dritter Ordnung der vierzählige außeraxiale Astigmatismus vierter Ordnung genutzt. Die in den Figuren widergegebenen Korrekturen einzelner axialer Bildfehler werden unter anderem in Justierverfahren zur Beseitigung axialer Bildfehler erster, zweiter und dritter Ordnung bei Korrektur des Öffnungsfehlers dritter Ordnung in elekronenoptischen Systemen eingesetzt.

## Patentansprüche

1. Verfahren zur Beseitigung eines axialen Bildfehlers in elektronenoptischen Systemen mit dem Bildfehler proportional zu αⁿ bzw α^{N}·α̅^{n-N}, wobei der von der optischen Achse aus gemessene und durch die komplexe Zahl α zusammengefaßte Öffnungswinkel nach Betrag und Azimut ist und somit n die Ordnung des Bildfehlers darstellt, **dadurch gekennzeichnet, daß** der außeraxiale Bildfehler der Ordnung n+m mit gleichem Verhalten in αⁿ, demnach also in der Form αⁿγ^{m} bzw. α^{N} α̅^{n-N} γ^{M} γ^{m-M}, durch Verschieben oder Verkippen des Strahlenganges zur optischen Achse soweit in Wirkung gebracht wird bis eine Kompensation des axialen Bildfehlers eintritt, wobei γ als komplexe Zahl die Bildkoordinaten in beiden Schnitten beschreibt.

2. Verfahren nach Anspruch 1, **dadurch gekennzeichnet, daß** der außeraxiale Fehler um eine Ordnung höher, also linear in γ oder γ̅ ist.

3. Verfahren nach Anspruch 2 zur Korrektur des vierzähligen axialen Astigmatismus dritter Ordnung, **gekennzeichnet durch** eine Verschiebung der optischen Achse solange, bis der außeraxiale vierzählige Astigmatismus vierter Ordnung (α̅³γ) zu einer völligen Kompensation führt.

4. Verfahren nach Anspruch 2 zur Korrektur des zweizähligen Sternfehlers dritter Ordnung S₃ (α³), **dadurch gekennzeichnet, daß** eine Verschiebung senkrecht zur optischen Achse solange erfolgt, bis der außeraxiale Sternfehler vierter Ordnung (γ·α³ bzw. γ̅· α³) den axialen Sternfehler dritter Ordnung vollständig kompensiert.

5. Verfahren nach einem der vorgehenden Ansprüchen, **dadurch gekennzeichnet, daß** die Verschiebung senkrecht zur optischen Achse im Bereich eines Zwischenbildes vorgenommen wird.

6. Verfahren zur Korrektur der axialen Koma zweiter Ordnung in elektronenoptischen Systemen mit korrigiertem Öffnungsfehler dritter Ordnung unter Verwendung von Hexapolen, **dadurch gekennzeichnet, daß** in zwei Hexapolen jeweils ein Quadrupolfeld gleicher Stärke überlagert wird, wobei das Produkt aus dem Vorzeichen des Hexapolfeldes und dem des diesen überlagerten Quadrupolfeldes einander entgegengerichtet sind.

7. Verfahren nach Anspruch 6, **dadurch gekennzeichnet, daß** das Quadrupolfeld durch Verschieben der optischen Achse parallel zur Achse des Hexapols erzeugt wird.

8. Verfahren zur Korrektur des dreizähligen axialen Astigmatismus zweiter Ordnung in elektronenoptischen Systemen mit korrigiertem Öffnungsfehler dritter Ordnung unter Verwendung von Hexapolen, **dadurch gekennzeichnet, daß** ein zusätzliches Haxapolfeld überlagert wird, daß zur Erzeugung des Hexapolfeldes zwischen benachbarten Hexapolen eine magnetische Rundlinse angeordnet ist, die eine virtuelle Drehung der beiden Hexapole relativ zueinander erzeugt.

9. Justierverfahren zur Beseitigung axialer Bildfehler erster, zweiter und dritter Ordnung bei Korrektur des Öffnungsfehlers dritter Ordnung in elektronenoptischen Systemen mit Hexapolen, **dadurch gekennzeichnet, daß**
- als erstes hinter dem elektronenoptischen System in der Bildebene der Wert der axialen Bildfehlerkoeffizienten erster, zweiter und dritter Ordnung ermittelt wird,
- zunächst in bekannter Weise durch Änderung der Fokussierung die Defokussierung C₁ und durch Überlagerung eines Quadrupolfeldes der zweizählige axiale Astigmatismus erster Ordnung korrigiert wird,
- anschließend die axiale Koma zweiter Ordnung B₂ entsprechend der Ansprüche 6 oder 7 und der dreizählige axiale Astigmatismus zweiter Ordnung entsprechend der Ansprüche 8 oder 9 korrigiert und
- hieran anschließend der vierzählige Astigmatismus dirtter Ordnung entsprechend Anspruch 3 sowie der Sternfehler dritter Ordnung nach einem der Ansprüche 4 oder 5 beseitigt wird,
- wobei nach erfolgter Korrektur die hierdurch entstandenen Fehler erster und zweiter Ordnung mit Hilfe spezieller, die dritte Ordnung nicht oder nur geringfügig beeinflußender Justierelemente beseitigt werden.

## Claims

1. Method for eliminating an axial image aberration in electron-optical systems wherein the image aberration is proportional, in magnitude and azimuth, to αⁿ or α^{N} α^{n-N}, wherein the divergence angle measured from the optical axis and summarised by the complex number α, and n thus represents the order of the image aberration, **characterised in that** the extra-axial image aberration of order n+m with the same behaviour in αⁿ, correspondingly in the form αⁿγ^{m} and α^{N} α^{n-N} γ^{M} γ̅^{m-M}, by shifting or tilting the ray path with respect to the optical axis, is made effective until compensation of the axial image aberration occurs, γ, as a complex number, describing the image coordinates in both sections.

2. The method according to claim 1, **characterised in that** the extra-axial aberration is one order higher, that is to say linear in γ or γ̅.

3. Method according to claim 2 for correction of the third-order axial astigmatism with fourfold symmetry **characterised by** a displacement of the optical axis until the fourth-order extra-axial astigmatism (α̅³γ) with fourfold symmetry leads to complete compensation.

4. Method according to claim 2 for correction of the third-order stellar aberration with twofold symmetry S₃ (α³), **characterised in that** displacement perpendicular to the optical axis takes place until the extra-axial fourth-order stellar aberration (γ· α³ and γ̅•α³) completely compensates the third order axial stellar aberration.

5. Method according to one of the preceding claims, **characterised in that** the displacement perpendicular to the optical axis is performed in the region of an intermediate image.

6. Method for correction of the second order axial coma in electron-optical systems with corrected third-order spherical aberration using hexapoles, **characterised in that**, in two hexapoles, a quadrupole field of equal intensity in each case is superimposed thereon, the product of the sign of the hexapole field and that of the quadrupole field superimposed thereon being opposed to one another.

7. Method according to claim 6, **characterised in that** the quadrupole field is generated by displacement of the optical axis parallel to the axis of the hexapole.

8. Method for correction of the second order axial astigmatism with twofold symmetry in electron-optical systems with corrected third-order spherical aberration using hexapoles, **characterised in that** an additional hexapole field is superimposed, **in that** a magnetic round lens is arranged to generate the hexapole field between adjacent hexapoles, which generates a virtual rotation of the two hexapoles with respect to one another.

9. Adjustment method for eliminating first, second and third order axial image aberrations in the correction of the third-order spherical aberration in electron-optical systems with hexapoles, **characterised in that**
- first, the value of the first, second and third-order axial image aberration coefficients is determined behind the electron-optical system in the image plane,
- then, in a known manner, the defocusing C₁ is corrected by changing the focusing and the first-order axial astigmatism with twofold symmetry is corrected by superimposing a quadrupole field,
- subsequently the second order axial coma B₂ is corrected according to claim 6 or 7 and the second-order axial astigmatism with threefold symmetry is corrected according to claim 8 or 9, and
- thereupon, the third-order astigmatism with fourfold symmetry is corrected according to claim 3 and the third-order stellar aberration is eliminated according to one of claims 4 or 5,
- after correction has been performed, the first and second order aberrations being eliminated by means of special adjustment elements that have little, if any, influence on the third order.

## Revendications

1. Procédé pour éliminer une erreur axiale d'image dans des systèmes optiques électroniques avec un erreur d'image proportionnelle à άⁿ ou ά^{N} ά^{n-N}, sachant que l'angle d'ouverture mesuré depuis l'axe optique et résumé d'après son montant et son azimut par le nombre complexe ά, n représentant par conséquent l'ordre de l'erreur d'image, **caractérisé par le fait que** l'erreur extra-axiale de l'ordre n+m avec le même comportement en άⁿ, par conséquent dans la forme άⁿγ^{m} ou ά^{N}ά^{nN}γ^{M}γ^{m-M}, est utilisé en décalant ou en faisant basculer le passage du rayon vers l'axe optique jusqu'à ce qu'apparaisse une compensation de l'erreur axiale d'image, sachant que γ décrit en tant que nombre complexe les coordonnées d'image dans les deux coupes.

2. Procédé selon la revendication 1 **caractérisé par le fait que** l'erreur extra-axiale est supérieure d'un ordre, c'est-à-dire linéaire γ ou γ.

3. Procédé selon la revendication 2 pour corriger l'astigmatisme axial à plusieurs chiffres de troisième ordre **caractérisé par** un décalage de l'axe optique jusqu'à ce que l'astigmatisme extra-axial de quatrième ordre (ά³γ) conduise à une compensation complète.

4. Procédé selon la revendication 2 pour corriger l'erreur d'étoile à deux chiffres S₃ (ά³), **caractérisé par le fait qu'**un décalage est effectué verticalement par rapport à l'axe optique jusqu'à ce que l'erreur extra-axiale de quatrième ordre (γ-ά³ ou γ-ά³) compense complètement l'erreur axiale d'étoile de troisième ordre.

5. Procédé selon une des revendications précédentes **caractérisé par le fait que** le décalage s'effectue verticalement par rapport à l'axe optique dans la zone d'une image intermédiaire.

6. Procédé pour corriger le coma axial de second ordre dans des systèmes optiques électroniques avec correction de l'erreur d'ouverture de troisième ordre en employant des hexapôles, **caractérisé par le fait qu**'un champ d'hexapôles de même intensité recouvre dans chaque cas deux hexapôles, sachant que le produit du signe du champ d'hexapôle et celui du champ d'hexapôle le recouvrant sont inverses.

7. Procédé selon la revendication 6, **caractérisé par le fait que** le champ d'hexapôle est créé en décalant l'axe optique parallèlement à l'axe de l'hexapôle.

8. Procédé pour corriger l'astigmatisme axial à trois chiffres de second ordre dans les systèmes optiques électroniques avec erreur d'ouverture en employant des hexapôles, **caractérisé par le fait qu'**un champ supplémentaire d'hexapôles est superposé, qui est disposé entre les hexapôles voisins d'une lentille ronde magnétique provoquant une rotation virtuelle des deux hexapôles l'un par rapport à l'autre.

9. Procédé d'ajustage pour éliminer les erreurs axiales d'image de premier, second et troisième ordre lors de la correction de l'ouverture d'image de troisième ordre dans les systèmes optiques électroniques avec des hexapôles, **caractérisé par le fait**
- **que** l'on détermine pour commencer au niveau de l'image, derrière le système optique électronique, la valeur des coefficients d'erreur axiale d'image de premier, second et troisième ordre,
- **que** l'astigmatisme axial de premier ordre est d'abord corrigé de la manière connue en modifiant le focussage et le défocussage C₁ et en superposant un champ de quadripôles,
- **qu'**ensuite le coma axial de second ordre B₂ est corrigé selon les revendications 6 et 7 et l'astigmatisme axial à trois chiffres de second ordre est corrigé selon les revendications 8 et 9 et
- **qu'**ensuite l'astigmatisme axial à quatre chiffres de troisième ordre est éliminé selon la revendication 3 et que l'erreur d'étoile de troisième ordre est éliminée selon une des revendications 4 ou 5,
sachant qu'après l'achèvement de la correction, les erreurs de premier et second ordre nées de ce fait sont éliminées à l'aide d'éléments d'ajustage spéciaux n'influençant pas, ou seulement marginalement, le troisième ordre.
